# EUROPEAN PATENT APPLICATION

(11) **EP 1 122 988 A2**
(43) Date of publication of application: **08.08.2001**
(21) Application number: 00308680.8
(22) Date of filing: 03.10.2000
(51) Int. Cl.: H05K 1/00

(54) **Mounting board, method of manufacturing the same and method of mounting electronic-circuit element**

(30) Priority: 28.01.2000 JP 2000020780
(71) Applicant: SANYO ELECTRIC CO., LTD., Moriguchi-shi, Osaka (JP)
(72) Inventor: Sakamoto, Noriaki, Yamada-gun, Gunma (JP); Kobayashi, Yoshiyuki, Oura-gun, Gunma (JP); Sakamoto, Junji, Ota-shi, Gunma (JP); Mashimo, Shigeaki, Seta-gun, Gunma (JP); Okawa, Katsumi, Ota-shi, Gunma (JP); Maehara, Eiju, Kiryu-shi, Gunma (JP); Takahashi, Kouji, Sawa-gun, Gunma (JP)
(74) Representative: Nicholls, Michael John

(57) **Abstract**

After a isolation trench is formed in a conductive foil 70, insulating resin 50 is coated on the conducting foil 70 serving as a supporting board. The conductive foil 70 is turned upside down. Using the insulating resin 50 as another supporting board, the conductive foil is ground so that it is separated into the conductive passages. Thus, the mounting board can be constructed and manufactured using necessary and minimum material. The mounting board which can prevent the conductive passages from coming off can be realized by embedding the conductive passages 51 in the insulating resin to curve the side wall of each conductive passage 51 and/or make a visor coated on the conductive passage.

## Description

The present invention relates to a mounting board, a method of manufacturing it and a method of mounting an electronic-circuit element, and more particularly to a mounting board having a substantially flat surface with a conductive passage embedded in insulating resin, a method of manufacturing it and a method of mounting an electronic-circuit element.

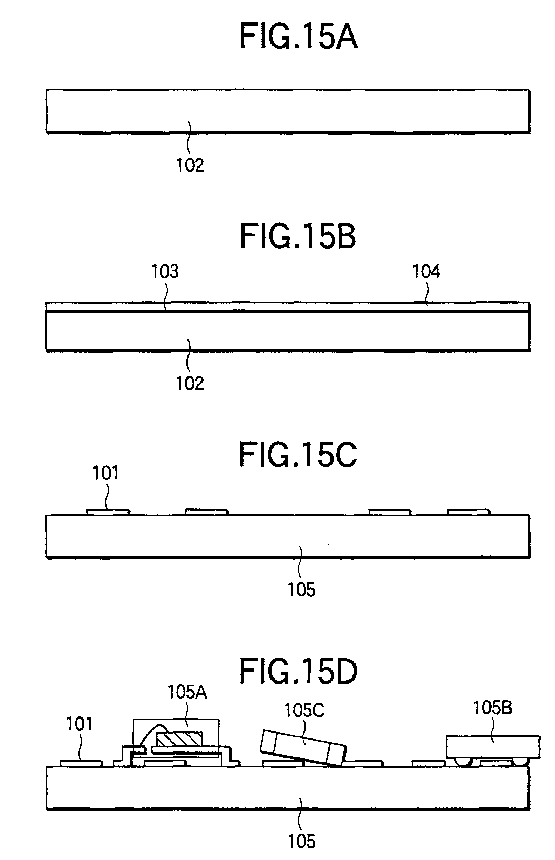

Conventionally, an electronic circuit device set in an electronic appliance is structured in such a manner that an electronic-circuit element is mounted on a printed board or ceramic board with a conductive passage formed. For example, it is manufactured in the process from making the printed board to mounting the electronic-circuit element as shown in Fig. 15 of the accompanying drawings.

First, as shown in Fig. 15A, a supporting substrate serving as a supporting member for a conductive passage 101 is prepared. The supporting substrate 102 is a resin substrate with glass fiber filled with epoxy resin, and has a thickness of about 1 mm.

Subsequently, as shown in Fig. 15B, a copper foil 104 which is covered with adhesive resin 103 is pasted on the supporting substrate 102 by crimping or thermal crimping. Generally, the copper foil 104 has a thickness of 18 µm or 35 µm.

As shown in Fig. 15C, the copper foil 104 is patterned to form conductive passages 101. Thus, a printed board 105 is completed in which the conductive passages 101 each having a thickness of 18 µm or 35 µm are pasted on the supporting board 102 having a large thickness of 1 mm.

Finally, as shown in Fig. 15D, electronic-circuit elements are mouthed on the printed board. Reference numeral 105A denotes a package sealed by common transfer molding, in which the periphery of a semiconductor chip is covered with a resin layer and a lead for external connection is extended out from the side of the resin layer. Reference numeral 105B denotes a face-down type of semiconductor device such as BGA, CSP, etc. in which a solder ball for external connection is formed on a chip surface. Reference numeral 105C denotes a passive element such as a chip capacitor, a chip resistor, etc.

By the manufacturing process described above, an electronic-circuit device can be realized in which an electronic-circuit elements are electrically connected through conductive passages to form a predetermined circuit.

The electronic circuit device in which these electronic-circuit elements 105 are mounted on the printed board 105 has been desired to be small and light because it is packaged in a small-and-light electronic appliance such as a portable telephone.

However, the supporting board 102 such as a printed board, metallic board or ceramic board is as thick as 1 mm. To reduce the thickness further has reached the limit. In addition, the electronic-circuit device in which the electronic-circuit elements are mounted on the substrate is wholly thick because the supporting board is relatively thick. Therefore, the electronic-circuit device becomes large in size and cannot be reduced in weight. Thus, the entire electronic appliance cannot be minimized.

Where the electronic-circuit elements are assembled into a circuit, necessary and minimum elements are electronic-circuit elements 105 and connecting means such as conductive passages 101, and the supporting board 102 is not essentially required. However, in the manufacturing process as shown in Fig. 15, the supporting board 102 for processing the copper foil 104 is necessary and cannot be removed. This applies to where the conductive passages are formed on a ceramic board or flexible sheet.

The structure in which the conductive passages are only deposited on the supporting board 102 presents a problem that the conductive passages may peel off or exfoliate and warp. Particularly, a pad with a very small area of bonding was remarkable in peeling-off, and a fine and long wire was remarkable in warp and peeling-off.

Further, as shown in Fig. 15D, the electrodes of the electronic-circuit elements 105 could not be arranged with high accuracy on the conductive passages and were not in the light place as the case may be. In this case, since the conductive passages 101 are as thick as 18 µm or 35µm, the electronic-circuit elements 105 could not be shifted. For example, when the electronic-circuit element 105A as shown in Fig. 15D is shifted horizontally, the lead wire was brought into contact with the side wall of the conductive passage 101 and was difficult to shift. In such a case, a worker must pick up an electronic-circuit element 105A and relocate it.

The present invention has been completed in view of the above problem. The present invention intends to small, easy to be mounted accurate and reliable circuit board.

The present invention intends to solve the problem by providing a mounting board having conductive passages embedded in insulating resin so that the insulating resin and the conductive passage are substantially flush with each other in their surfaces.

Since the conductive passages and the insulating resin are flush with each other in their surfaces, the mounted electronic-circuit element can be shifted so that it is not brought into contact with the side wall of each conductive passage.

Particularly, the electronic-circuit element mounted in misalignment can be shifted horizontally so that it can be relocated in position. Further, if the solder is being molten after the electronic-circuit element is mounted, the misaligned electronic-circuit element itself tends to return to onto the conductive passages due to the surface tension of the molten solder so that it can be relocated in position.

Preferably, the invention solves the problem by providing a mounting board having conductive passages embedded in insulating resin so that the insulating resin and the conductive passage are substantially flush with each other in their surfaces and the side wall of each of the conductive passages is curved.

The curved side wall of the conductive passage provides the anchor effect to prevent the conductive passage from coming off. Particularly, the curved structure prevents the fine and long wiring from exfoliating.

Preferably, the present invention solves the problem by providing a mounting board having conductive passages embedded in insulating resin so that the insulating resin and the conductive passage are substantially flush with each other in their surfaces, and the rear surface of each of the conductive passages is coated with a second material that is different from the first material constituting the conductive passages.

Generally, owing to the difference between the insulating resin and the first material in their thermal expansion coefficients, the mounting board itself may warp or the conductive passages may curve or peel off. Since the first material has a higher thermal conductive coefficient than that of the insulating resin, the first material early raises its temperature and expands. Therefore, the covering of the second material having the thermal expansion coefficient that is lower than that of the first material prevents the warp and peeling of the conductive passages and the warp of the mounting board. Where Cu is adopted for the first material, the second material is preferably Ag or Ni.

Preferably, the present invention solves the problem by providing a mounting board having conductive passages embedded in insulating resin so that the insulating resin and the conductive passage are substantially flush with each other in their surfaces, the rear surface of each of the conductive passages is coated with a second material that is different from the first material constituting the conductive passages, and the second material constitutes a visor(protorubance).

Since the coating of the second material is formed on the surface of the conductive passage, the visor fixed on the conductive passage can be formed. Like the second solving means, the anchor effect can be generated, thereby preventing the conductive passage from warping or coming off.

Preferably the present invention solves the problem in such a manner that the first material is mainly composed of Cu and the second material is mainly composed of Ni or Ag. Cu and Ni can be etched using the etchant such as ferric chloride or cupric chloride. In this case, since Ni has a smaller etching rate than that of Cu, the visor of Ni can be formed. Ag and Cu can be selectively etched so that the visor can be formed.

Preferably, the present invention solves the problem in such a manner that the insulating resin is composed of single resin.

In the conventional structure as shown in Fig. 15, in order to prevent the conductive passage from be exfoliated, the other resin for covering the conductive passage is required. On the other hand, in the present invention, the conductive passages are embedded in the insulating resin and the side wall of the conductive passage is caused to have the anchor effect. Therefore, the mounting board can be constructed of the single insulating resin and the conductive passages.

Preferably, the present invention solves the problem in such a manner that the surface of the conductive passages is located at a lower level than that of the insulating resin.

Where the surface of the conductive passages is located at a lower level than that of insulating resin, the concaved portion of the insulating resin is formed on the periphery the conductive passage. Therefore, where the leads are arranged on the corresponding conductive passages, the side wall of the concaved portion of the insulating resin serves as a stopper to prevent the electronic-circuit element from being displaced. Therefore, even when the lead is deviated from the conductive passage, it can be shifted horizontally since it is located on the insulating resin.

Preferably, the present invention solves the problem in such a manner that each of the conductive passages constitutes an electrode, a bonding pad, a die pad region or a wiring.

Preferably, the present invention solves the problem in such a manner that level of a part of region of the conductive passages corresponding to the die pad is lower than that of the other region.

According to the above structure, a level of chip surface is made lower than that of the bonding pad of the leads. Therefore, short circuit can be prevented.

Preferably, the present invention solves the problem by providing a method of manufacturing a mounting board comprising the steps of: preparing a conductive foil; removing the conductive foil at the areas except those constituting at least conductive passages so that its thickness is smaller than the original thickness of the conductive foil, thereby forming a isolation trench;
depositing insulating resin on the surface of the conductive foil and the isolation trench; and chemically or physically removing the rear surface of the conductive foil to form the conductive passages separated by the isolation trench.

In accordance with this method, the mounting board can be manufactured by necessary and minimum materials of the conductive foil and insulating resin. In addition, when the insulating resin is coated, the conductive foil constituting the conductive passages is used as the supporting board. When the conductive foil is separated into the conductive passages, it is turned upside down and the insulating resin is used as the supporting board. Thus, the mounting board can be made using necessary and minimum conductive passages and insulating resin. As described in connection with the prior art, the present invention does not use the printed board which is not essentially necessary to constitute a circuit, thereby reducing the production cost of the mounting board. Further, the mounting board can be made to have a very small thickness because the printed board is not required, the conductive passages are embedded in the insulating resin and the thickness of the insulating resin and conductive passage can be adjusted.

The step of reducing the thickness of the conducive foil (e.g. "half etching") can be performed without isolation the conductive passages from one another so that the subsequent step of coating the insulating resin can be carried out with improved workability.

Tenthly, the present invention solves the problem by providing the step of cutting, grinding, etching the rear surface of the conductive foil so that the insulating resin and the conductive passages are substantially flush with each other in their surface.

Since the rear surface of the conductive surface is cut, ground or etched until the insulating resin is exposed so that the conductive passages and the insulating resin are flush with each other in their surfaces, the electronic-circuit element can be easily mounted and relocated later.

Preferably, the present invention solves the problem in such a manner that the conducive foil is composed of a first conductive material and a second conductive material coated thereon, and a visor of the second conducive material is formed when the isolation trench is formed.

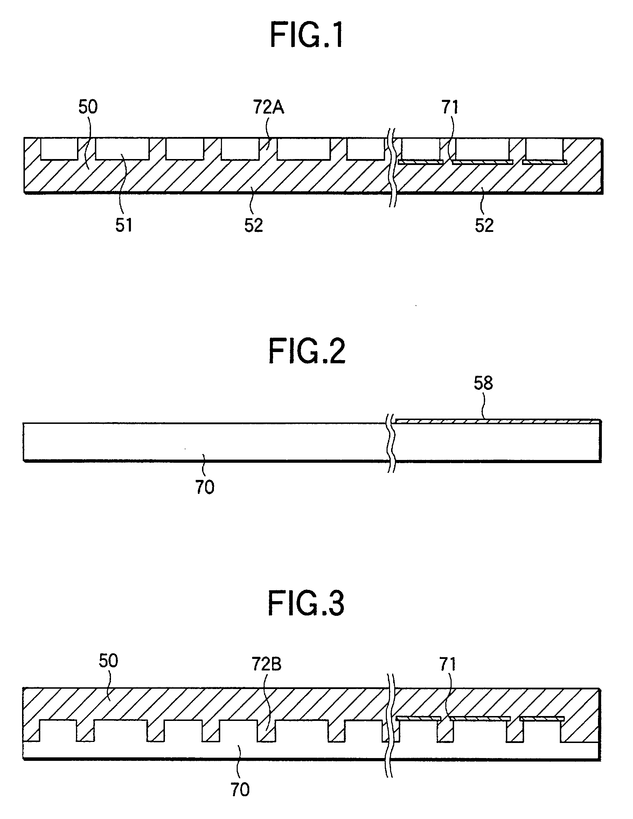

As shown in Fig. 3, since the visor is formed on the rear surface of the conductive passage when the conductive foil is separated into the conductive passages, the anchor effect by the visor can be generated.

Preferably, the present invention solves the problem in such a manner that the first material is mainly composed of Cu and the second material is mainly composed of Ni. When the conductive passages are formed using the etchant such as ferric chloride or cupric chloride, since Ni has a smaller etching rate than that of Cu, the visor of Ni can be formed.

Preferably, the present invention solves the problem by providing a method of manufacturing a mounting board comprising the steps of: preparing a conductive foil; forming a corrosion-resistant conductive coating on regions constituting conductive passages of the conductive foil; removing the conductive foil using the conductive coating so that its thickness is smaller than the original thickness of the conductive foil, thereby forming a isolation trench; depositing insulating resin on the surface of the conductive foil and the isolation trench; and chemically or physically removing the rear surface of the conductive foil to form the conductive passages separated by the isolation trench.

Fourteenthly, the present invention solves the problem in such a manner that the corrosion-resistant conductive coating is made of any one selected from the group consisting of Ag, Au, Pt and Pd.

If the region constituting the conductive passage is selectively covered with the Ag coating having corrosion-resistance against the etching solution, this coating serves as an etching protecting film. Therefore, the isolation trench can be etched without using the photoresist.
This applies the other conductive coatings. The corrosion-resistant conductive coating can be used as a die pad or bonding pad as at it is.

For example, Ag can be glued to Au or brazing material. Therefore, if a chip is coated with an Au coating on its rear surface, the chip can be thermally crimped on the Ag coating. Au can be bonded to the brazing material and also bonded to a thread of Au. Therefore, the above conductive coating can be uses as a die pad or bonding pad as it is.

Preferably, the present invention solves the problem in such a manner that the insulating resin is composed of single resin.

Preferably, the present invention solves the problem in such a manner that the surface of the conductive passages is located at a lower level than that of the insulating resin.

Preferably, the present invention solves the problem by providing a method of mounting an electronic-circuit element comprising the steps of: preparing a mounting board having conductive passages embedded in insulating resin so that the insulating resin and the conductive passage are substantially flush with each other in their surfaces; and
mounting an electronic-circuit element on the conductive passages so that it can be shifted so as to be relocated in position.

Since the conductive passages and the insulating resin are flush with each other in their surfaces, even when the electronic-circuit is misaligned, it can be easily shifted in position.

Preferably, the present invention solves the problem by providing a method of mounting an electronic-circuit element comprising the steps of: preparing a mounting board having conductive passages embedded in insulating resin so that the insulating resin and the conductive passage are substantially flush with each other in their surfaces; and
mounting an electronic-circuit element on the conductive passages through a solder material so that it can be shifted by surface tension of molten solder so as to be relocated in position.

Even when the electronic-circuit element is misaligned, as long as solder is molten, the electronic-circuit element is spontaneously relocated in position. The relocation using a mounting machine or a worker can be saved.

The invention will be further described by way of example with reference to the accompanying drawings, in which:-

Fig. 1 is a view showing a mounting board according to the invention.

Fig. 2 is a view for explaining a method of making the mounting board according to the invention.

Fig. 3 is a view for explaining a method of making the mounting board according to the invention.

Fig. 4 is a perspective view of Fig. 3.

Fig. 5 is a view showing the mounting board according to the invention in which an electronic-circuit element is mounted.

Fig. 6 is a view showing the mounting board according to the invention.

Fig. 7 is a view for explaining a method of making the mounting board according to the invention.

Fig. 8 is a view for explaining a method of making the mounting board according to the invention.

Fig. 9 is a view showing the mounting board according to the invention.

Fig. 10 is a view showing the mounting board according to the invention in which an electronic-circuit element is mounted.

Fig. 11 is a view showing the mounting board according to the invention.

Fig. 12 is a view showing the mounting board according to the invention.

Fig. 13 is a view showing the mounting board according to the invention.

Fig. 14 is a view showing the mounting board according to the invention.

Fig. 15 is a view for explaining a conventional method of making a mounting board.

### Embodiment 1 of a mounting board

Now referring to Fig. 1, an explanation will be given of the structure of the mounting board according to the invention. As seen, the mounting board is divided into a right part and a left part having different structures separated by a wavy line.

The left part of Fig. 1 shows a mounting board 52 having conductive passages 51 embedded in insulating resin 50 so that the insulating resin and the conductive passage are substantially flush with each other in their surfaces.

This structure is composed of two materials of a plurality of conductive passages 51 and insulating resin in which these conductive passages 51 are embedded. Among these conductive passages 51, a isolation portion 72A is formed. The isolation portion 72A and the conductive passages 51 are flush with each other in their surfaces.

The insulating resin may be thermosetting resin such as epoxy resin, polyimide resin, etc. or otherwise thermoplastic resin such as polyphenylene sulfide. The conductive passages 51 may be made of a conductive foil mainly containing Cu or Al, or composed of an alloy such as Fe - Ni.

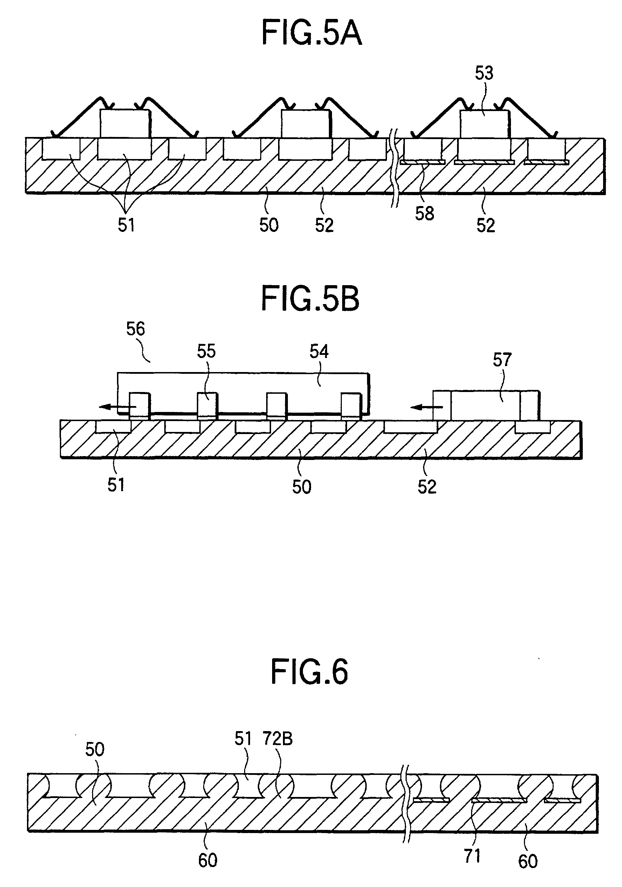

The feature of this structure resides in that the insulating resin 50 and the conductive passages 51 are substantially flush with each other in their surfaces. This structure, which has no step, has a feature that the electronic-circuit element 53 can be horizontally shifted as it is. The feature is described later in connection with Fig. 5.

### Embodiment 2 of the mounting board

An explanation will be given of the mounting board 52 illustrated at the right part of Fig. 1

The mounting board 52 has a conductive passage 51 embedded in insulating resin 50 so that the insulating resin and the conductive passage are substantially flush with each other in their surfaces. In addition, in the mounting board 52, the rear surface of each of the conductive passages 51 is made of a second material different from the first material constituting the conductive passages 51.

The structure of the mounting board 52 is substantially the same as that of the left part of Fig. 1 except that the rear surface of the conductive passages 51 is made of the second material. Therefore, the mounting board 52 has the following two features in addition to the features described in connection with the structure of the left part of Fig. 1.

The first feature is the provision of the second material for preventing the warp of the conductive passages and the mounting board.

Generally, owing to the difference between the insulating resin and the first material in their thermal expansion coefficients, the mounting board itself may warp or the conductive passages may curve or peel off. Since the first material has a higher thermal conductive coefficient than that of the insulating resin, the first material early raises its temperature and expands. Therefore, the covering of the second material having the thermal expansion coefficient that is lower than that of the first material prevents the warp and exfoliation of the conductive passages and the warp of the mounting board. Where Cu is adopted for the first material, the second material is preferably Ag or Ni.

The second feature is to provide the anchor effect by the second material. The second material constitutes a visor 71. The visor 71 deposited on the conductive passage 51, which is embedded in the insulating resin 50, provides the anchor effect and hence prevents coming-off of the conductive passage 51.

### Embodiment 3 of the mounting board

An explanation will be given of a mounting board 60 shown at the left part in Fig. 6. The mounting board 60 has a conductive passages 51 embedded in insulating resin 50 so that the insulating resin and the conductive passage are substantially flush with each other in their surfaces.
The side wall of each of the conductive passages 51 embedded in the mounting board 60 is curved.

Since this structure is substantially the same as that of the left part of Fig. 1 except the curved structure, only the curved structure will be explained here.

This curved structure can be formed by non-anisotropic etching which will be clarified in connection with the manufacturing process described later. Particularly, on the side of the conductive passage 51, the upper side and/or the lower side protrudes outwardly so that the curved structure provides the anchor effect, thereby preventing the coming-off of the conductive passage 51.

### Embodiment 4 of the mounting board

An explanation will be given of the mounting board 60 at the right part of Fig. 6. The mounting board 60 is substantially the same as that of the left part except the visor 71 formed on the rear surface of the conductive passage.

As understood from the explanation hitherto made, the anchor effect can be mainly given by two kinds of structures, i.e. visor 71 and curving of the side wall of the conductive passage 51. The mounting board 60 according to this embodiment adopts both structures to prevent the coming-off of the conductive passage 51 more effectively. When the Ni having a thickness of 1- 7 µm deposited on the Cu foil having a thickness of 70 µm is subjected to wet etching by ferric chloride or cupric chloride, the visor 71 having a length of about 5 - 15 µm is generated.

### Embodiment 5 of the mounting board

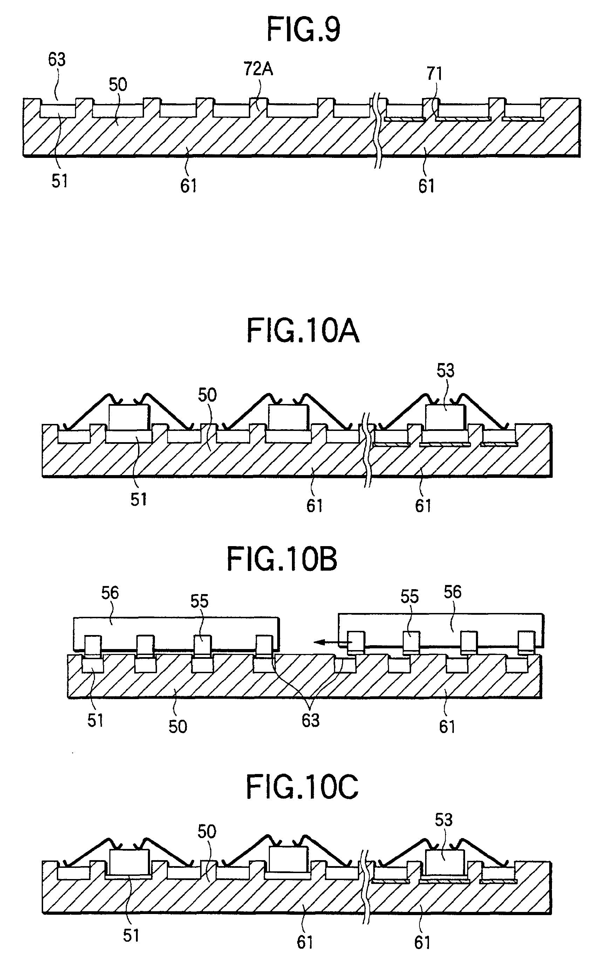

An explanation will be given of the mounting board 61 at the left part in Fig. 9.
The mounting board 61 has conductive passages 51 embedded in insulating resin 50 so that conductive passage 51 is lower than the insulating resin 50 in their surfaces. The structure of the mounting 61 according to this embodiment is substantially the same as that of the left part of Fig. 1 except that the surface of the conductive passage 51 is lower.

The feature of the mounting board 61 resides in that the surface of the conductive passage 51 is made low. Where a lead terminal 55 of the electronic-circuit element is suitably arranged in the conductive passage 51 with the surface made low, its connecting portion is located in a concave portion 63. Therefore, the connection portion is brought into contact with the side wall of the concave portion and not be shifted. The details will be described in later in Fig. 10B.

### Embodiment 6 of the mounting board

An explanation will be given of the mounting board 61 of the right part of Fig. 9.
The mounting board 61 according to this embodiment has conductive passages 51 embedded in insulating resin 50 so that conductive passage 51 is lower than the insulating resin 50 in their surfaces and also the rear surface of the conductive passage 51 is formed of the second material different from the first material to constitute a visor. The mounting board 61 according to this embodiment is substantially the same as the left part of Fig. 9 except that the visor 71 is formed.

The mounting board 61 according to this embodiment is characterized in that the surface of the conductive passage 51 is made low. Where an electronic-circuit element is suitably arranged on the conductive passages 51, the lead terminal 55 of the electronic-circuit element is brought into contact with the side wall of the concave portion 63 and not shifted. The mounting board 61 according to this embodiment is also characterized in that the coming-off of the conductive passage 51 is prevented by the anchor effect of the visor.

Further as another embodiment, as shown in Fig. 10C, a level of a region of the conductive passages corresponding to the die pad is lower than that of the other region.

According to the above structure, a level of chip 53 surface is made lower than that of the bonding pad of the leads. Therefore, short circuit caused by contacting a bonding wire with the chip surface can be prevented.

### Embodiment 7 of the mounting board

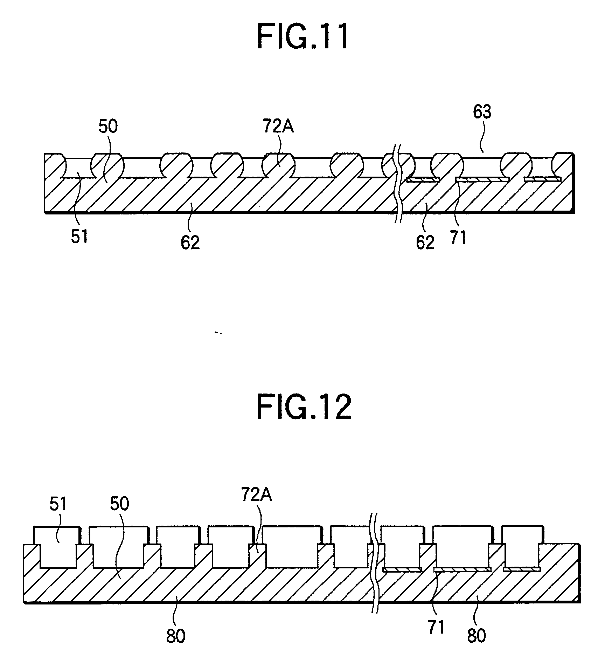

An explanation will be given of a mounting board 62 at the left part of Fig. 11.
The mounting board 62 has conductive passages 51 embedded in insulating resin 50 so that conductive passage 51 is lower than the insulating resin 50 in their surfaces and the side wall of the conductive passage 51 is curved.
The structure of the mounting 61 according to this embodiment is substantially the same as that of the left part of Fig. 6 except that the surface of the conductive passage 51 is lower.

The mounting board 61 according to this embodiment is characterized in that the surface of the conductive passage 51 is made low. Where the electronic-circuit element is suitably arranged on the conductive passages 51, the lead terminal 55 of the electronic-circuit element is brought into contact with the side wall of the concave portion 63 and not shifted. The mounting board 61 according to this embodiment is also characterized in that the coming-off of the conductive passage 51 is prevented by its curved structure.

### Embodiment 8 of the mounting board

An explanation will be given of the mounting board 62 at the right part of Fig. 11.
The mounting board 62 has conductive passages 51 embedded in insulating resin 50 so that conductive passage 51 is lower than the insulating resin 50 in their surfaces, the side of the conductive passage 51 is curved and the visor is formed. Incidentally, the structure of the mounting 62 according to this embodiment is substantially the same as that of the left part of Fig. 11 except that the visor is formed, and also substantially the same as the right part of Fig. 6 except that the surface of the conductive passage 51 is made lower than the insulating resin 50.

The mounting board 62 according to this embodiment is characterized in that the surface of the conductive passage 51 is made low. Where the electronic-circuit element is suitably arranged on the conductive passages 51, the lead terminal 55 of the electronic-circuit element is brought into contact with the side wall of the concave portion 63 and not shifted. The mounting board 61 according to this embodiment is also characterized in that the coming-off of the conductive passage 51 is prevented by its curved structure and the provision of the visor.

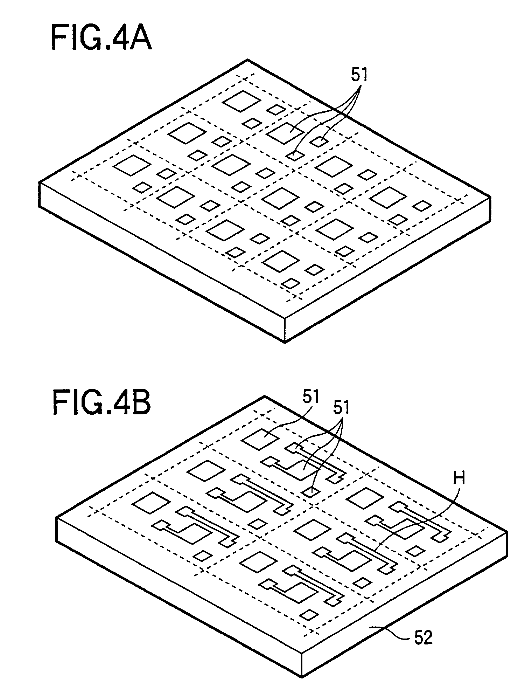

Referring to Fig. 4, an explanation will be given of the design of the conductive passages. The conductive passages 51 can be formed in various patterns so that they can be adopted as various kinds of electrodes, die pads, bonding pads and wirings. It is very significant that the conductive passages can be applied to the wirings. Specifically, a certain hybrid board or a printed board has the wiring pattern in which the wiring is fine and long to extend from the one end of the board to the other end thereof. The fine and long wiring has a problem that when heated, it is likely to warp and when subjected to a heat cycle, it peels.
Further, the conductive passage having a small size such as a bonding pad is likely to peel off because it has a small bonding area. However, in accordance with the present invention, the conductive passage is embedded in the insulating resin 50. In addition, the conductive passage 51 has a curved side structure and/or the visor is formed to produce the anchor effect. Therefore, the present invention can solve these problems at a stroke. This applies to all the mounting boards described hitherto.

Embodiment 1 of the method of manufacturing a mounting board.

Referring to the left side of Fig. 2, left side of Fig. 3, and left side of Fig. 1, an explanation will be given of a method of manufacturing a mounting board 52.

First, as shown in Fig. 2, a sheet-like conductive foil 70 is prepared. The conductive foil 70 is selected in view of the adhesive characteristic of a solder material, bonding or plating property. The material may be a conductive foil mainly containing Cu or Al, or composed of an alloy such as Fe - Ni.

In view of the etching to be carried out later, the thickness of the conductive foil is preferably 10 pm - 300 µm. In this embodiment, the copper foil having 70 µm (2 ounce) was adopted. The conductive foil may basically have a thickness not smaller than 300 µm and not larger than 10 µm as long as a isolation trench 72B that is more shallow than the thickness of the copper foil 70 can be formed.

The sheet-like conductive foil 70 wound in a roll having a prescribed width may be prepared and transferred to each of the steps described later. Otherwise, the pieces of the conductive foil cut into prescribed sizes may be prepared and transferred to the steps described later.

For the area except at least the regions constituting the conductive passages 51, a step of removing the conductive foil 70 to reduce the thickness is executed. Subsequently, a step of covering the isolation trench 72B thus formed and the conductive foil 70 with the insulating resin 50 is executed.

In these steps, photoresist is deposited on the Cu foil 70. The photoresist is patterned to expose the conductive foil 70 except the regions constituting the conductive passages 51. Etching is executed through the photoresist.

The isolation trench 72B formed by etching has a depth of e.g. 50 µm. The side wall of the isolation trench 72B is coarse to improve its bonding strength with the insulating resin 50.

Further, the isolation trench 72 is schematically illustrated on the straight, but may has a different structure according to the method of removal. The step of removal can be executed by wet etching, dry etching, evaporation by laser or dicing. The Cu foil may be dented by stamping. In the case of the wet etching, the etchant may be mainly ferric chloride or cupric chloride. The conductive foil is dipped in the etchant or otherwise subjected to the shower ring by the etchant. The wet etching generally carries out non-anisotropic etching to provide a curved side wall. The details will be explained in connection with the manufacturing method shown in Figs. 6 - 8.

In the case of the dry etching, the etching can be carried out in anisotropy or non-anisotropy. At present, it is the that Cu cannot be removed by the reactive ion etching, but sputtering. The etching can be executed in anisotropy or non-anisotropy according to the condition in sputtering.

The laser permits the isolation trench to be formed by direct application of the laser light, and makes the mask for etching unnecessary.

The dicing cannot make a curved complicated pattern, but can make the isolation trench in a grid.

On the left side of Fig. 2, if the regions constituting the conductive passages are selectively covered with a conductive coating having corrosion-resistance against the etching solution, this conductive coating is serves as an etching protecting film. Therefore, the isolation trench can be etched without using the photoresist. Such a conductive coating may be made of Ag, Au, Pt, Ni or Pd. The corrosion-resistant conductive coating can be used as a die pad or bonding pad as at it is.

For example, Ag can be glued to Au and solder. Therefore, if a chip is coated with an Au coating on its rear surface, the chip can be thermally crimped on the Ag coating. The chip can be also fixed through the brazing material such as solder. A thread of Au can be bonded to the conductive coating of Ag, thereby permitting wire bonding. Therefore, the above conductive coating can be used as a die pad or bonding pad as it is.

The step of depositing the insulating resin 50 on the conductive foil 70 and isolation trench 72B can be executed by transfer mold, injection mold, or dipping. The resin material may be the thermosetting resin such as epoxy resin, polyimide resin in the transfer molding, and the thermoplastic resin such as polyphenylene sulfide in the injection molding.

In this embodiment, the insulating resin covered on the surface of the conductive foil 70 has a thickness of about 100 µm. This thickness may be made increased or decreased in view of the strength.

The process according to this embodiment is characterized in that the conductive foil 70 constituting the conductive passage 51 serves as a supporting board when the insulating resin 50 is covered. Conventionally, as shown in Fig. 15C, the supporting board 102 that is not essentially required is adopted to provide the conductive passages 101. On the other hand, in the present invention, the conductive foil 70 serving as the supporting board is a material required as an electrode material. This provides the merit of saving the component material and reducing the production cost.

The isolation trench 72B is formed to be more shallow than the thickness of the conductive foil so that the conductive foil 70 is not individually separated into pieces of the conductive passages 51. Therefore, the sheet-like conductive foil 70 can be dealt with as an integral body. This provides a feature of facilitating the transfer to the mold, and work of the mounting in the molding by the insulating resin (see the left part of Fig. 3).

Next, as shown in Fig. 1, the rear surface of the conductive foil 70 is removed chemically and/or physically to separate the conductive foil into the individual conductive passages 51. In Fig. 3, the conductive foil 70 is located down, whereas in Fig. 1, the conductive foil is upside down for the purpose of removal from above. The removal step can be executed by the techniques of grinding, cutting, etching and metal evaporation by laser.

In an experiment, the entire surface of the conductive foil 70 was removed away by the thickness of about 30 µm to expose the insulating resin. As a result, the conductive foil was separated into the conductive passages 51 each having a thickness of about 40 µm. Otherwise, until the insulating resin 50 is exposed, the entire surface of the conductive foil 70 may be wet-etched and thereafter may be removed away by the grinding or cutting machine to expose the insulating resin 50. Furthermore, until the insulating resin 50 is exposed, the entire surface of the conductive foil 70 may be removed by the grinding or cutting machine and thereafter may be wet-etched to expose the insulating resin 50.

As a result, the structure in which the surface of the conducive passages 51 is exposed to the insulating resin 50. Fig. 4 shows such a state. Fig. 4A shows an application of the mounting board for transistors. Fig. 4B shows an application of the mounting board in which a plurality of electronic-circuit elements are formed and wirings H are connected to the elements to constitute an electronic circuit. Either board can be prepared as a monolithic board and manufactured in a matrix shape. The board is divided into a plurality of parts before or after the electronic-elements are mounted by dotted lines. However, a single circuit may be formed by the monolithic board and may be used exactly as it is.

Thus, a flat mounting board can be completed in which the conductive passages 51 are embedded in the insulating resin 50 and the insulating resin 50 and the conductive passages 51 are flush with each other in their surfaces.

The feature of the process according to this embodiment is characterized in that the insulating 50 can be used as the supporting board to separate the conductive passages 51 from each other. The insulating resin 50 is a material necessary to embed the conductive passages 51. Unlike the conventional manufacturing method as shown in Fig. 15, this process does not use an unnecessary board 102. Accordingly, this process permits the mounting board with a minimum amount of material and at a reduced cost.

The thickness of the insulating resin from the rear surface of the conductive passage can be adjusted when the insulating resin is deposited in the previous step. Therefore, the thickness of the mounting board 52 can be correspondingly increased or decreased. In this embodiment, the mounting board was completed in which the conductive passages 51 each having a thickness of 40 µm are embedded in the insulating resin 50 having a thickness of 140 µm (see Fig. 1).

Embodiment 2 of the method of manufacturing a mounting board.

Referring to the right side of Fig. 2, right side of Fig. 3, and right side of Fig. 1, an explanation will be given of a method of manufacturing a mounting board 52 having a visor 71. This process, which is substantially the same as the left side of Fig. 2, left side of Fig. 3, and left side of Fig. 1 except that a second material 58 is deposited, will not be explained in detail.

First, as shown in Fig. 2, a conductive foil 70 is prepared which is covered with the second material 58 having a small etching rate on the conductive foil 70 made of the first material.

For example, where the Cu foil is covered with Ni, both Cu and Ni can be simultaneously etched using ferric chloride or cupric chloride. Owing to the difference between them in the etching rate, Ni preferably constitutes the visor 71. The bold line denotes the Ni material 58 having a thickness of preferably 1 - 10 µm. The visor can be more easily formed as the thickness of Ni increases.

The second material may be a material which can be selectively etched from the first material. In this case, the coating of the second material is patterned to cover the regions where the conductive passages 51 are to be formed. Using this coating as a mask, the coating on the first material is etched to form the visors. The second material may be Al, Ag, Au, etc.

For the area except at least the regions constituting the conductive passages 51, a step of removing the conductive foil 70 to reduce the thickness is executed. Subsequently, a step of covering the isolation trench 72B thus formed and the conductive foil 70 with the insulating resin 50 is executed.

In these steps, photoresist is formed on Ni 58. The photoresist is patterned to expose the Ni 58 except the regions constituting the conductive passages 51. Etching is executed through the photoresist to form the visor of Ni.

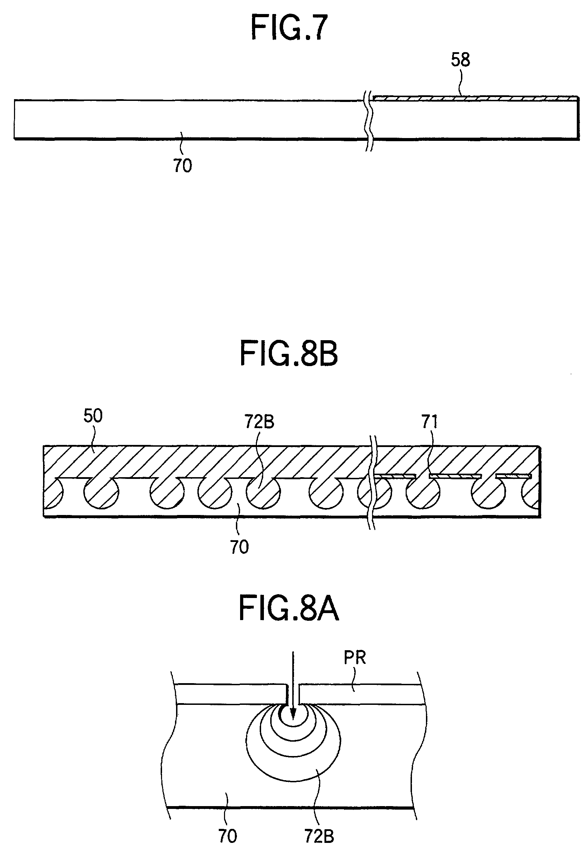

The conductive foil 70 and isolation trench 72B are covered with the insulating resin 50 (left side of Fig. 8A). As shown in Fig. 6, the rear surface of the conductive foil 70 is removed chemically and/or physically to separate the conductive foil into the individual conductive passages 51. Since these steps (Fig. 1) are essentially the same as the process described previously, they are not further explained.

Embodiment 3 of the method of manufacturing a mounting board.

Referring to the left side of Fig. 7, left side of Fig. 8, and left side of Fig. 6, an explanation will be given of a method of manufacturing a mounting board 60 in which the side wall of each of the conductive passages is curved.

First, as shown in the left side of Fig. 7, a sheet-like conductive foil 70 is prepared. In this embodiment, in order to effect non-anisotropic etching and realize the curved structure of the side wall, a copper foil having a thickness of 70 µm (2 ounce) was adopted. If the copper foil is too thin, the isolation trench will reach the rear surface because of the high etching speed. The thickness is selected taking this fact into consideration.

For the area except at least the regions constituting the conductive passages 51, a step of removing the conductive foil 70 to reduced the thickness is executed. Subsequently, a step of covering the isolation trench 72B thus formed and the conductive foil 70 with the insulating resin 50 is executed.

For example, on the left side of Fig. 8A, photoresist is formed on the Cu foil 70. The photoresist is patterned to expose the conductive foil 70 except the regions constituting the conductive passages 51. Etching is executed through the photoresist.

The manufacturing process according to this embodiment adopts wet etching or dry etching in which the isolation trench is non-anisotropically etched so that the side wall is coarse and curved. The isolation trench 72B formed by etching has a depth of e.g. 50 µm.

In the case of the wet etching, the etchant may be mainly ferric chloride or cupric chloride. The conductive foil is dipped in the etchant or otherwise subjected to the showering by the etchant.

As shown in Fig. 8B, in the area immediately below the photoresist PR serving as an etching mask, the etching is difficult to advance laterally. In the area which is deeper than the above area, the etching advances laterally.
As seen from Fig. 8B, where the diameter of an opening becomes smaller upward from a certain point of the side wall of the isolation trench 72B, an inverted-tapered structure is created to provide the anchor structure. The showering permits the etching to advance in a direction of depth and suppresses the etching to advance in a lateral direction, so that the anchor structure is revealed remarkably.

On the left side of Fig. 7, on the basis of the theory described above, a similar anchor structure can also be formed by partially plating the region corresponding to the conductive passage with the metal such as Ag, Au, Pd or Pt and making the wet etching using the metal as a mask.

The step of depositing the insulating resin 50 on the conductive foil 70 and isolation trench 72B can be executed by transfer mold, injection mold, or dipping. The resin material may be the thermosetting resin such as epoxy resin, polyimide resin in the transfer molding, and the thermoplastic resin such as polyphenylene sulfide in the injection molding.

In this embodiment, the insulating resin covered on the surface of the conductive foil 70 has a thickness of about 100 µm. This thickness may be made increased or decreased in view of the strength.

This process according to this embodiment is characterized in that the conductive foil 70 constituting the conductive passage 51 serves as a supporting board when the insulating resin 50 is covered. Conventionally, as shown in Fig. 15C, the supporting board 102 that is not essentially required is adopted to provide the conductive passages 101. On the other hand, in the present invention, the conductive foil 70 serving as the supporting board is a material required as an electrode material. This provides the merit of saving the component material and reducing the production cost.
In addition, the isolation trench 72B is formed to be more shallow than the thickness of the conductive foil so that the conductive foil 70 is not individually separated into pieces of the conductive passages 51. Therefore, it can be dealt with as the sheet-like conductive foil 70. This provides a feature of facilitating the transfer to the mold, and work of the mounting (see the left side of Fig. 8).

Next, as shown in Fig. 6, the rear surface of the conductive foil 70 is removed chemically and/or physically to separate the conductive foil into the individual conductive passages 51. In Fig. 8A, the conductive foil 70 is located down, whereas in Fig. 6, the conductive foil is upside down for the purpose of removal from above. The removal step can be executed by the techniques of grinding, cutting, etching and metal evaporation by laser.

In this embodiment, the entire surface of the conductive foil 70 was cut away by the thickness of about 30 µm to expose the insulating resin. As a result, the conductive foil was separated into the conductive passages 51 each having a thickness of about 40 µm.

Otherwise, until the insulating resin 50 is exposed, the entire surface of the conductive foil 70 may be wet-etched and thereafter may be cut away by the grinding or cutting machine to expose the insulating resin 50, Further, until the insulating resin 50 is exposed, the entire surface of the conductive foil 70 may be removed away and thereafter may be wet-etched to expose the insulating resin 50. The conductive foil may be etched from the rear surface until it is separated into the conductive passages.

As a result, the structure is completed in which the surface of the conducive passages 51 is exposed from the insulating resin 50. In addition, a flat mounting board can be completed in which the conductive passages 51 are embedded in the insulating resin 50 and the insulating resin 50 and the conductive passages 51 are flush with each other in their surfaces.
The feature of the process according to this embodiment is characterized in that the insulating 50 can be used as the supporting board to separate the conductive passages 51 from each other. The insulating resin 50 is a material necessary to embed the conductive passages 51. Unlike the conventional manufacturing method as shown in Fig. 15C, this process does not use an unnecessary board 102. Accordingly, this step permits the mounting board with a minimum amount of material and at a reduced cost.

Since the side wall of the conductive passage is curved, it will not come off from the insulating resin 50.
In this embodiment also, the conductive passages 51 each having a thickness of 40 µm were embedded in the insulating resin 50 having a thickness of 140 µm (see Fig. 6).
Embodiment 4 of the method of manufacturing a mounting board.

Referring to the right side of Fig. 7, right side of Fig. 8, and right side of Fig. 6, an explanation will be given of a method of manufacturing a mounting board 52 provided with the conductive passages each having the curved side wall and with the visors. This process, which is substantially the same as the previous process except that the visor 71 is provided , will not be explained in detail.

First, as shown in Fig. 7, a sheet-like conductive foil 70 is prepared which is coated with the second material 58

For the area except at least the regions constituting the conductive passages 51, a step of removing the conductive foil 70 to reduce the thickness is executed. Subsequently, a step of covering the isolation trench 72B thus formed and the conductive foil 70 with the insulating resin 50 is executed.

In these steps, on the left side of Fig. 8A, photoresist is deposited on Ni 58. The photoresist is patterned to expose the Ni 58 except the regions constituting the conductive passages 51. Etching is executed through the photoresist.

The conductive foil 70 and isolation trench 72B are covered with the insulating resin 50 (left side of Fig. 8A). The rear surface of the conductive foil 70 is removed chemically and/or physically to separate the conductive foil into the individual conductive passages 51.

As a result, the structure is completed in which the surface of the conducive passages 51 is exposed to the insulating resin 50. In addition, a flat mounting board can be completed in which the conductive passages 51 are embedded in the insulating resin 50 and the insulating resin 50 and the conductive passages 51 are flush with each other in their surfaces. Since the side wall of the conductive passage is curved and the visor is provided, the conductive passages will not come off from the insulating resin 50 (Fig. 6).

Embodiment 5 of the method of manufacturing a mounting board.

Referring to the left side of Fig. 2, left side of Fig. 3, left side of Fig. 1 and left side of Fig. 9, an explanation will be given of a method of manufacturing a mounting board 61 in which the conductive passages 51 are located at a lower level. This process adopts the same steps until the left side of Fig. 2, left side of Fig. 3 and left side of Fig. 1 which are not explained here.

In the step of Fig. 1, after the conductive passages 51 and insulating resin 50 are made flush with each other in their surfaces, the conductive passages 51 are further etched by wet etching or dry etching. Thus, the surface of each conductive passage 51 is located at a lower level than that of the insulating resin 50.

On the left side of Fig. 3, if the foil 70 is entirely etched, the conductive passages 51 are naturally separated from the each other. If the etching is further continued, the surface of the conductive passages 51 will be located at a lower level than that of the insulating resin.

The step of locating the conducting passages 51 at a lower level makes trenches 63 which prevents the lead terminals 55 to be displaced.

Embodiment 6 of the method of manufacturing a mounting board.

Referring to the right side of Fig. 2, right side of Fig. 3, right side of Fig. 1 and right side of Fig. 9, an explanation will be given of a method of manufacturing a mounting board 61 provided with the visors. This process adopts the same steps until the right side of Fig. 2, right side of Fig. 3 and right side of Fig. 1 which are not explained here.

In the step of Fig. 1, after the conductive passages 51 and insulating resin 50 are made flush with each other in their surfaces, the conductive passages 51 are further etched by wet etching or dry etching. Thus, as shown on the right side in Fig. 9, the surface of each conductive passage 51 is located at a lower level than that of the insulating resin 50.

On the right side of Fig. 3, if the foil 70 is entirely etched, the conductive passages 51 are naturally separated from the each other. If the etching is further continued, the surface of the conductive passages 51 will be located at a lower level than the insulating resin.

Embodiment 7 of the method of manufacturing a mounting board.

Referring to the left side of Fig. 7, left side of Fig. 8A, left side of Fig. 6 and left side of Fig. 11, an explanation will be given of a method of manufacturing a mounting board 62. This process adopts the same steps until the left side of Fig. 7, left side of Fig. 8A and left side of Fig. 6 which are not explained here.

In the step of Fig. 6, after the conductive passages 51 and insulating resin 50 are made flush with each other in their surfaces, the conductive passages 51 are further etched by wet etching or dry etching. Thus, as shown in Fig. 11, the surface of each conductive passage 51 is located at a lower level than that of the insulating resin 50.

On the left side of Fig. 8, if the foil 70 is entirely etched, the conductive passages 51 are naturally separated from the each other. If the etching is further continued, the surface of the conductive passages 51 will be located at a lower level than the insulating resin.

Embodiment 8 of the method of manufacturing a mounting board.

Referring to the right side of Fig. 7, right side of Fig. 8A, right side of Fig. 6 and right side of Fig. 11, an explanation will be given of a method of manufacturing a mounting board 62. This process adopts the same steps until the right side of Fig. 7, right side of Fig. 8A and right side of Fig. 6 which are not explained here.

In the step of Fig. 6, after the conductive passages 51 and insulating resin 50 are made flush with each other in their surfaces, the conductive passages 51 are,further etched by wet etching or dry etching. Thus, as shown in Fig. 11, the surface of each conductive passage 51 is located at a lower level than that of the insulating resin 50.

On the right side of Fig. 8, if the foil 70 is entirely etched, the conductive passages 51 are naturally separated from the each other. If the etching is further continued, the surface of the conductive passages 51 will be located at a lower level than that of the insulating resin.

Embodiment 9 of the method of manufacturing a mounting board.

Referring to Figs. 2, 3 and 12, an explanation will be given of a mounting board 80 as shown in Fig. 12.

This process adopts the steps shown in Figs. 2 and 3 which are not explained here.

In Fig. 3, the conductive foil 70 is etched using an etching mask covering the regions corresponding to the conductive passages until it is divided into the conductive passages 51. Then, a mounting board 80 as shown in Fig. 12 is formed. In this structure, the conductive passages 51 are formed so that their surface protrudes from that of the insulating resin 50. However, since each of the conductive passages 51 is partially embedded in the insulating resin, its coming-off can be prevented.

Embodiment 10 of the method of manufacturing a mounting board.

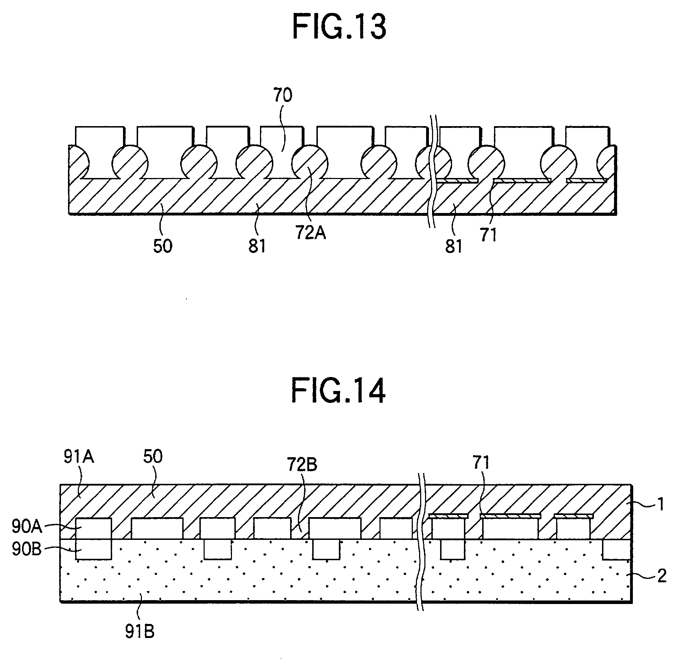

Referring to Figs. 7, 8 and 13, an explanation will be given of a mounting board 80 as shown in Fig. 13.

In Fig. 8, the conductive foil 70 is etched using an etching mask covering the regions corresponding to the conductive passages until it is divided into the conductive passages 51. Then, a mounting board 81 as shown in Fig. 13 is formed. In this structure, the conductive passages 51 are formed so that their surface protrudes from that of the insulating resin 50. However, since each of the conductive passages 51 is partially embedded in the insulating resin, its coming-off can be prevented.

### Embodiment 1 of the mounting method

Referring to Fig. 5, an explanation will be given of a method of mounting an electronic-circuit element 56. Fig. 5B shows the mounting board on which a package-type electronic-circuit element 56 is mounted.

Now it is assumed that a lead is misaligned on the conductive passage. In this case, in the conventional technique, a possible step or level difference becomes an obstacle to shift the lead. On the other hand, in the present invention, since the insulating resin 50 and conductive passage 51 are flush with each other in their surfaces, the lead can be easily shifted.

When the electronic-circuit element 56 is provisionally fixed using applied solder, as the case may be, it is misaligned. However, in the present invention, since the conductive passage and the insulating resin are flush with each other in their surfaces, the electronic-circuit element has only to be horizontally shifted to be located in position. Where a mounting machine is used, it has only to be moved laterally. This improves the workability of the mounting machine.

Further, even when the electronic-circuit element is misaligned in its provisional fixing using the paste, it can be spontaneously relocated in position by the reflow of solder due to the surface tension of molten paste. Particularly, since the conductive passages and the insulating resin are flush with each other, the electronic-circuit element can be easily relocated in position.

In accordance with the structure according to this embodiment, even when electronic-circuit elements 56 and 57 are misaligned from the corresponding conductive passages, if the solder can be molten again, these elements will be spontaneously moved to the corresponding conductive passages 51 owing to the surface tension of the molten solder. Thus, the they can be relocated in position.

In recent years, both conductive passages 51 and electronic-circuit elements have become minute, it is frequent that the electronic-circuit elements are misaligned. However, the structure of the mounting board according to this embodiment suppresses inconvenience of misaligning the electronic-circuit elements (Fig. 5).

### Embodiment 2 of the mounting method

Referring to Fig. 10, an explanation will be given of the method of mounting an electronic-circuit element. As seen from Fig. 10, the surface of the conductive passages 51 is located at a lower level than that of insulating resin to form concaved portions 63. Therefore, where the lead terminals 55 of the electronic-circuit element 56 are arranged on the corresponding conductive passages 51, they are surrounded by the concaved portions 63, respectively, and hence are not shifted because of the steps or level differences formed on the periphery.
Further as shown in Fig.14 as another embodiment, relocated wiring structure and multilayered structure by adhering a plurality of the mound boards of the present invention can be obtained.

First, a first mount board 91A comprising first conductive passages 90A embedded in insulating resin so that said insulating resin and said first conductive passage are substantially flush with each other, and a second mount board 91B comprising second conductive passages 90B embedded in insulating resin so that said insulating resin and said first conductive passage are substantially flush with each other are prepared.

Then the first mount board 91A is contacted with the second mount board 91B so as to facing a first and second conductive passages each other;

And then the insulating resin is hardened with pressing and heating to be melt and cooled in a mold die , thereby adhered the first and second mount board.

By removing chemically or physically the insulating resin the rear surface of said conductive foil, the conductive passages is isolated by said isolation trench.

And then electric circuit element is mounted on the conductive passage of the first mound board and at last by removing chemically or physically the insulating resin the rear surface of said second conductive passage is exposed.

According to the above method, relocated structured semiconductor device can be obtained easily.

As understood from the explanation hitherto made, in accordance with the present invention, the mounting board can be made using necessary and minimum components of conductive passages and insulating resin. Conventionally, a supporting board was required to make the conductive passages. However, in accordance with the invention, when the insulating resin is deposited, the conductive foil constituting the conductive passages is adopted as the supporting board, and when the conductive foil is separated into the conductive passages, the insulating resin into which the conductive passages are embedded is adopted as the supporting board. Therefore, the mounting board can be realized with no redundant component and at greatly reduced cost. Further, the mounting board can be made to have a very small thickness by adjusting the thickness of the insulating resin to be covered and of the conductive foil.

Since the conductive passages and the insulating resin are flush with each other in their surfaces, the mounted electronic-circuit element can be shifted so that it is not brought into contact with the side wall of each conductive passage.

Using a difference in the thermal expansion coefficient, the second material formed on the rear surface of the conductive passage suppresses warp of the mounting board, and warp/exfoliation of the conductive passages (particularly, long wires).

The curved side wall of the conductive passage provides the anchor effect to prevent the conductive passage from coming off. Particularly, the curved structure prevents the fine and long wiring from being exfoliated.

The coating of the second material formed on the surface of the conductive passage generates a visor fixed thereon to provide the anchor effect. This prevents the conductive passage from warping or coming off.

Cu and Ni can be etched using the etchant such as ferric chloride or cupric chloride. In this case, since Ni has a smaller etching rate than that of Cu, the visor of Ni can be formed.

When the insulating resin is coated, the conductive foil constituting the conductive passages is used as the supporting board. When the conductive foil is separated into the conductive passages, it is turned upside down and the insulating resin is used as the supporting board. Thus, the mounting board can be made using necessary and minimum components of conductive passages and insulating resin. As described in connection with the prior art, the present invention does not use the printed board which is not essentially necessary to constitute a circuit, thereby reducing the production cost of the mounting board. Further, the mounting board can be made to have a very small thickness because the printed board is not required, the conductive passages are embedded in the insulating resin and the thickness of the insulating resin and conductive passage can be adjusted.

The step of reducing the thickness of the conducive foil (e.g. "half etching") can be performed without isolation the conductive passages from one another so that the subsequent step of coating the insulating resin can be carried out with improved workability.

Since the conductive passages and the insulating resin are flush with each other in their surfaces, the mounted electronic-circuit element can be shifted so that it is not brought into contact with the side wall of each conductive passage. Particularly, the electronic-circuit element mounted in misalignment can be shift horizontally so that it can be relocated in position.

Further, as long as the solder is being molten after the electronic-circuit element is mounted, the misaligned electronic-circuit element itself tends to return to onto the conductive passages due to the surface tension of the molten solder so that it can be relocated in position.

Where the surface of the conductive passages is located at a lower level than that of insulating resin, the concaved portion of the insulating resin is formed on the periphery of the conductive passage. Therefore, where the leads are arranged on the corresponding conductive passages, the side wall of the concaved portion of the insulating resin serves as a stopper to prevent the electronic-circuit element from being displaced. Even when the lead is deviated from the conductive passage, it can be shifted horizontally since it is located on the insulating resin.

## Claims

1. Amounting board comprising conductive passages embedded in insulating resin so that said insulating resin and said conductive passage are substantially flush with each other in their surfaces.

2. A mounting board according to claim 1, wherein the side wall of each of the conductive passages is curved.

3. A mounting board according to claims 1 or 2, wherein the rear surface of each of said conductive passages is coated with a second material that is different from the first material constituting said conductive passages.

4. A mounting board according to claim 3, wherein said second material constitutes a visor.

5. A mounting board according to claim 3 or 4, wherein said first material is mainly composed of Cu and the second material is mainly composed of Ni or Ag.

6. A mounting board according to claim 1, 2, 3, 4 or 5, wherein said insulating resin is composed of single resin.

7. A mounting board according to any one of the preceding claims, wherein the surface of said conductive passages is located at a lower level than that of said insulating resin.

8. A mounting board according to any one of the preceding claims, wherein each of said conductive passages constitutes an electrode, a bonding pad, a die pad region or a wiring.

9. A mounting board according to claim 8, wherein a level of a part of region of the conductive passages corresponding to the die pad is lower than that of the other region.

10. A method of manufacturing a mounting board comprising the steps of:
preparing a conductive foil;
removing the conductive foil at the areas except those constituting at least conductive passages so that its thickness is smaller than the original thickness of the conductive foil, thereby forming a isolation trench;
depositing insulating resin on the surface of said conductive foil and in the isolation trench; and
removing chemically or physically the rear surface of said conductive foil to form the conductive passages separated by said isolation trench.

11. A method of manufacturing a mounting board according to claim 10, said removing step comprises the step of cutting, grinding, or etching the rear surface of said conductive foil so that said insulating resin and the conductive passages are substantially flush with each other in their surface.

12. A method of manufacturing a mounting board according to claim 10 or 11, wherein said conducive foil is composed of a first conductive material and a second conductive material coated thereon, and a visor of the second conducive material is formed when said isolation trench is formed.

13. A mounting board according to claim 12, wherein said first material is mainly composed of Cu and the second material is mainly composed of Ni or Ag.

14. A method of manufacturing a mounting board according to claim 10, said removing step comprises the steps of:
forming a corrosion-resistant conductive coating on regions constituting conductive passages of the conductive foil;
removing the conductive foil using said conductive coating so that its thickness is smaller than the original thickness of the conductive foil, thereby forming a isolation trench.

15. A method of manufacturing a mounting board according to claim 14, wherein said corrosion-resistant conductive coating is made of any one selected from the group consisting of Ag, Au, Pt and Pd.

16. A method of manufacturing a mounting board according to any one of claims 10 to 15, wherein said insulating resin is composed of single resin.

17. A method of manufacturing a mounting board according to any one of claims 10 to 16, wherein the surface of said conductive passages is located at a lower level than that of said insulating resin.

18. A method of manufacturing a mounting board according to claim 10, wherein comprising the steps of:
preparing a first mount board comprising first conductive passages embedded in insulating resin so that said insulating resin and said first conductive passage are substantially flush with each other;
preparing a second mount board comprising second conductive passages embedded in insulating resin so that said insulating resin and said first conductive passage are substantially flush with each other;
contacting the first mount board with the second mount board so as to facing a first and second conductive passages each other;
hardening the insulating resin with pressing, thereby adhering the first and second mount board; and
removing chemically or physically the rear surface of said conductive foil to form the conductive passages isolated by said isolation trench.

19. A method of mounting an electronic-circuit element comprising the steps of:
preparing a mounting board having conductive passages embedded in insulating resin so that said insulating resin and said conductive passage are substantially flush with each other in their surfaces; and
mounting an electronic-circuit element on the conductive passages so that it can be shifted so as to be relocated in position.

20. A method of mounting an electronic-circuit element according to claim 19, wherein said mounting step comprises the step of
mounting an electronic-circuit element on the conductive passages through a solder material so that it can be shifted by surface tension of molten solder so as to be relocated in position.
